# EUROPÄISCHE PATENTSCHRIFT

(11) **EP 0 785 297 B1**
(45) Veröffentlichungstag und Bekanntmachung des Hinweises auf die Patenterteilung: **05.01.2000**
(21) Anmeldenummer: 97200458.4
(22) Anmeldetag: 19.03.1990
(51) Int. Cl.: C25D 3/38, H05K 3/24

(54) **Wässriges, saures Bad zur galvanischen Abscheidung von glänzenden und rissfreien Kupferüberzügen und Verwendung dieses Bades**
An aqueous acid bath for the electrodeposition of a shiny and tear-free copper coating and its application
Bain aqueuse acide pour le dépôt électrolytique d'une couche de cuivre brilliante, sans fissures et son application

(43) Veröffentlichungstag der Anmeldung: 23.07.1997
(73) Patentinhaber: ATOTECH Deutschland GmbH, 10553 Berlin (DE)
(72) Erfinder: Dahms, Wolfgang, D-13437 Berlin (DE)
(74) Vertreter: Effert, Bressel und Kollegen

(56) Entgegenhaltungen:
- DE-A- 2 746 938
- US-A- 3 294 578
- US-A- 3 502 551
- US-A- 4 336 114
- US-A- 4 781 801

## Beschreibung

Die Erfindung betrifft ein wäßriges, saures Bad zur galvanischen Abscheidung von glänzenden und rißfreien Kupferüberzügen, insbesondere zur Verstärkung der Leiterbahnen von gedruckten Schaltungen mit hervorragender Bruchelongation, das mindestens ein Kupfersalz und mindestens eine anorganische Säure sowie eine eine Amidgruppe aufweisende Verbindung und eine organische Thioverbindung mit wasserlöslich machenden Gruppen enthält.

Es ist seit langem bekannt, daß galvanischen Kupferbädern bestimmte organische Substanzen zugesetzt werden, um eine glänzende Abscheidung zu erzielen. Vielfach führen aber die Zusätze zur Verschlechterung der mechanischen Eigenschaften, insbesondere der Härte und Bruchelongation sowie zu Passivitätserscheinungen, die eine nachfolgende Aktivierung für die Weiterbehandlung erforderlich machen. Außerdem verschlechtern viele Inhibitoren die Metallstreuung, so daß Risse an Bohrungen und Kanten entstehen, besonders wenn die Kupferschicht beim Löten gedruckter Schaltungen einer thermischen Behandlung ausgesetzt ist.

Die zahlreichen, für diesen Zweck bereits bekannten Verbindungen, wie zum Beispiel Thioharnstoff, Thiohydantoin, Thiocarbaminsäureester oder Thiophosphorsäureester, besitzen jedoch keine praktische Bedeutung, da die Qualität der mit ihnen erhaltenen Kupferüberzüge, insbesondere die Härte und Bruchelongation, sehr schlecht ist. Auch Kombinationen dieser Verbindungen mit anderen Zusätzen, wie zum Beispiel mit Ethylenoxid-Additionsverbindungen oder Polyaminen, führten nicht zu befriedigenden Ergebnissen.

Einen deutlichen Fortschritt ergaben Kupferbäder. die Säureamide der allgemeinen Formel R-CO-NH₂, in der R einen aliphatischen oder aromatischen monomeren oder polymeren Kohlenwasserstoffrest bedeuten. enthalten in Kombination mit einer sauerstoffhaltigen, hochmolekularen Verbindung und einer organischen Thioverbindung mit wasserlöslich machenden Gruppen (DE-OS 27 46 938).

Sie haben jedoch den Nachteil, nur in einem engen Konzentrationsbereich optimal zu wirken, der häufig in der Praxis nicht eingehalten werden kann. Es entstehen beim Überschuß von wenigen Milligramm pro Liter Badlösung Bohrlochabflachungen, so daß die Schaltungen beim späteren Löten Risse bekommen und unbrauchbar sind.

Aus der US-A-3,502,551 ist außerdem ein wäßriges saures Kupferbad, enthaltend mindestens ein Kupfersalz, mindestens eine anorganische Säure und gegebenenfalls ein Chlorid sowie eine eine Säureamidgruppe aufweisende aliphatische Kohlenwasserstoffverbindung, eine sauerstoffhaltige, hochmolekulare organische Verbindung und eine organische Thioverbindung mit wasserlöslich machenden Gruppen bekannt, mit dem die Glanzbildung und die Einebnung verbessert werden sollen. Als eine Säureamidgruppe aufweisende aliphatische Kohlenwasserstoffverbindung ist beispielsweise N-Polyvinylcaprolactam genannt.

Aufgabe der vorliegenden Erfindung ist daher die Schaffung eines galvanischen Kupferbades, welches zur Abscheidung glänzender Kupferüberzüge und zur Verstärkung der Leiterbahnen von gedruckten Schaltungen ohne Rißbildung und mit hervorragender Bruchelongation in großen Konzentrationsbereichen geeignet ist.

Diese Aufgabe wird erfindungsgemäß durch ein galvanisches Kupferbad gemäß dem kennzeichnenden Teil des Patentanspruchs gelöst.

Weitere Ausgestaltungen der Erfindung sind den kennzeichnenden Teilen der Unteransprüche zu entnehmen.

Das erfindungsgemäße Bad ermöglicht überraschenderweise die galvanische Abscheidung von Kupferüberzügen in breiten Konzentrationsbereichen mit besonders gleichmäßigem Glanz, die außerdem den überraschenden Vorteil einer guten Metallstreuung und einer ausgezeichneten Bruchelongation aufweisen. Die unter Verwendung des erfindungsgemäßen Bades abgeschiedenen Kupferüberzüge sind daher insbesondere zur Verstärkung der Leiterbahnen von gedruckten Schaltungen geeignet.

Die im erfindungsgemäßen Bad enthaltenen Einzelkomponenten scheinen sich bei ihrer gemeinsamen Verwendung gegenseitig in ihrer Wirkung in dem gewünschten Sinne zu verstärken, da sie bei ihrer alleinigen Verwendung keine zufriedenstellenden Ergebnisse bringen.

Die im erfindungsgemäßen Bad enthaltenen Einzelkomponenten sind an sich bekannt und können in an sich bekannter Weise hergestellt werden.

In der folgenden Tabelle I sind erfindungsgemäß zu verwendende Lactamalkoxylate sowie die bevorzugten Anwendungskonzentrationen dieser Verbindungen aufgeführt.

**Tabelle I**

| Lactamalkoxylate | bevorzugte Konzentration g / Liter |
|---|---|
| β - Propiolactam-äthoxylat | 0,02 - 2 |
| γ - Butyrolactam-hexa-äthoxylat | 0,01 - 2 |
| δ - Valerolactam-octa-äthoxylat | 0,03 - 3 |
| δ - Valerolactam-penta-propoxylat | 0,01 - 1 |
| ε - Caprolactam-hexa-äthoxylat | 0,02 - 2 |
| ε - Caprolactam-dodeca-äthoxylat | 0,01 - 1 |

Die folgende Tabelle II enthält Beispiele für organische Thioverbindungen mit wasserlöslich machenden Gruppen zur zusätzlichen Verwendung als Komponente und deren bevorzugte Anwendungskonzentrationen:

**Tabelle II**

| Thioverbindungen | bevorzugte Konzentration g/Liter |
|---|---|
| 3-Mercaptopropan-1-sulfonsäure, Natriumsalz | 0,005 - 0,1 |
| | |
| Thiophosphorsäure-O-ethyl-bis-(ω-sulfopropyl)-ester, Dinatriumsalz | 0,01 - 0,15 |
| | |
| Thiophosphorsäure-tris-(ω-sulfopropyl)-ester, Trinatriumsalz | 0,02-0,15 |
| | |
| Thioglykolsäure | 0,001 - 0,003 |
| | |
| Ethylendithiodipropylsulfonsäure, Natriumsalz | 0,01-0,1 |
| | |
| Di-n-propyl-thioether-di-ω-sulfonsäure, Dinatriumsalz | 0,01-0,1 |
| | |
| Bis-(ω-sulfopropyl)-disulfid, Dinatriumsalz | 0,002-0,02 |
| | |
| Bis-(ω-sulfohydroxypropyl)-disulfid, Dinatriumsalz | 0,003 - 0,02 |
| | |
| Bis-(ω-sulfobutyl)-disulfid, Dinatriumsalz | 0,004 - 0,02 |
| | |
| Bis-(p-sulfophenyl)-disulfid, Dinatriumsalz | 0.01-0,1 |
| | |
| Methyl-(ω-sulfopropyl)-disulfid, Natriumsalz | 0,007 - 0,03 |
| | |
| Methyl-(ω-sulfobutyl)-trisulfid, Natriumsalz | 0,005-0,02 |
| | |
| 3-(Benzthiazolyl-2-thio)-propylsulfonsäure, Natriumsalz | 0,008 - 0,04 |
| | |
| N,N-Dimethyl-dithiocarbaminsäure-(3-sulfopropyl)-ester, Natriumsalz | 0,003 - 0,02 |
| | |
| O-Ethyl-dithiokohlensäure-S-(3-sulfopropyl)-ester, Kaliumsalz | 0,001 - 0,015. |

Die folgende Tabelle III enthält Beispiele für sauerstoffhaltige, hochmolekulare Verbindungen, die gegebenenfalls zusätzlich, vorzugsweise als Tensid, verwendet werden können, sowie deren bevorzugte Anwendungskonzentrationen:

**Tabelle III**

| Sauerstoffhaltige hochmolekulare Verbindungen | bevorzugte Konzentrationen g/Liter |
|---|---|
| Polyvinylalkohol | 0,05 - 0,4 |
| Carboxymethylcellulose | 0,05 - 0,1 |
| Polyethylenglykol | 0,1-5,0 |
| Polypropylenglykol | 0,05-1,0 |
| Stearinsäure-polyglykolester | 0,5 - 8,0 |
| Ölsäure-polyglykolester | 0,5 - 5,0 |
| Stearylalkohol-polyglykolether | 0,5 - 8,0 |
| Nonylphenol-polyglykolether | 0,5 - 6,0 |
| Octanol-polyalkylenglykolether | 0,05 - 0,5 |
| Octandiol-bis-(polyalkylenglykolether) | 0,05 - 0,5 |
| Polyoxypropylenglykol | 0,05 - 0,5 |
| Polyethylen-propylenglykol (Misch- oder Blockpolymerisat) | 0,02 - 5,0 |
| β-Naphthol-polygylkolether | 0,02-4,0. |

Die Einzelkomponenten des erfindungsgemäßen Kupferbades können im allgemeinen vorteilhaft innerhalb folgender Grenzkonzentrationen im anwendungsfertigen Bad enthalten sein:

| | |
|---|---|
| Lactamalkoxylate | 0,002 - 3 g/Liter |
| vorzugsweise | 0,005 - 0,2 g/Liter |
| | |
| Organische Thioverbindungen mit wasserlöslich machenden Gruppen: | |
| | 0,0005 - 0,2 g/Liter |
| vorzugsweise | 0,001 - 0,05 g/Liter |
| | |
| Sauerstoffhaltige, hochmolekulare Verbindungen | |
| | 0,005 - 20 g/Liter |
| vorzugsweise | 0,01 - 5 g/Liter |

Die Grundzusammensetzung des erfindungsgemäßen Bades kann in weiten Grenzen schwanken. Im allgemeinen wird eine wäßrige Lösung folgender Zusammensetzung benutzt:

| | |
|---|---|
| Kupfersulfat (CuSO₄ . 5 H₂O) | 20 - 250 g/Liter |
| vorzugsweise | 60 - 100 g/Liter |
| oder | 180 - 220 g/Liter |
| Schwefelsäure | 50 - 350 g/Liter |
| vorzugsweise | 180 - 220 g/Liter |
| oder | 50 - 90 g/Liter |
| | |
| Chloridionen (in Form von Salzsäure oder Natriumchlorid) | 0,02 - 0,15 g/Liter |
| vorzugsweise | 0,025 - 0,08 g/Liter |

Anstelle von Kupfersulfat können zumindest teilweise auch andere Kupfersalze benutzt werden. Auch die Schwefelsäure kann teilweise oder ganz durch Fluoroborsäure, Methansulfonsäure oder andere Säuren ersetzt werden. Die Zugabe von Chloridionen kann ganz oder teilweise entfallen, wenn in den Zusätzen bereits Halogenionen enthalten sind.

Außerdem können im Bad auch zusätzlich übliche Glanzbildner, Einebner, wie zum Beispiel Thioharnstoffderivate, und/oder Netzmittel enthalten sein.

Zur Herstellung des erfindungsgemäßen Bades werden die Einzelkomponenten der Grundzusammensetzung hinzugefügt.

Die Arbeitsbedingungen des Bades sind wie folgt:

| | |
|---|---|
| pH-Wert | < 1 |
| Temperatur | 15 - 45° C, |
| vorzugsweise | 25° C |
| kathodische Stromdichte | 0,5 - 12 A/dm² |
| vorzugsweise | 2 - 4 A/dm² |

Elektrolytbewegung erfolgt durch Einblasen von sauberer Luft; so stark, daß sich die Elektrolytoberfläche in starker Wallung befindet. Die Elektrolytbewegung durch Lufeinblasen kann in einigen Fällen durch eine geeignete Warenbewegung ersetzt werden. Als Anode wird Kupfer mit einem Gehalt von 0,02 bis 0,067 % Phosphor verwendet.

Die folgenden Beispiele dienen zur Erläuterung der Erfindung:

### Beispiel 1

Einem Kupferbad der Zusammensetzung
40 g/Liter Kupfersulfat (CuSO₄·5 H₂O)
300 g/Liter Schwefelsäure konz.
0,1 g/Liter Salzsäure (35 %ig)
werden
3 mg/Liter O-Ethyl-dithiokohlensäure-S-(3-sulfopropyl)-ester, K-Salz und
50 mg/Liter ε-Caprolactam-hexa-ethoxylat
zugesetzt. Die Abscheidung ist in der Hullzelle von 0,15 A/dm² bis 4 A/dm² gut glänzend.

### Beispiel 2

Einem Kupferbad der Zusammensetzung
72 g/Liter Kupfersulfat (CuSO₄·5 H₂O)
200 g/Liter Schwefelsäure konz.
0,15 g/Liter Salzsäure (35 %ig)
werden
20 mg/Liter 3-(Benzthiazolyl-2-thio)-propylsulfonsäure, Na-Salz und
20 mg/Liter ε-Caprolactam-hexa-ethoxylat
zugefügt.

Man erhält bis 7 A/dm² eine glänzende Abscheidung.

Nach Zugabe von
0,4 g/Liter Polyethylen-propylenglykol
erhält man eine hervorragend glänzende Abscheidung, die sich auch auf der Rückseite des Hullzellenbleches fortsetzt.

### Beispiel 3

Einem Kupferbad der Zusammensetzung
80 g/Liter Kupfersulfat (CuSO₄·5 H₂O)
180 g/Liter Schwefelsäure konz.
0,08 g/Liter Natriumchlorid
werden als Glanzbildner
0,6 g/Liter Polypropylenglykol und
0,02 g/Liter 3-Mercaptopropan-1-sulfonsaures Natrium
zugegeben. Bei einer Badtemperatur von 30°C erhält man in der Hullzelle bei einer Stromdichte oberhalb von 5 A/dm² und bei einer Stromdichte unterhalb von 0,8 A/dm² matte Abscheidungen.

Setzt man dem Bad
0,1 g/Liter γ-Butyrolactam-hexa-ethoxylat oder
0,05 g/Liter ε-Caprolactam-hexa-ethoxylat oder
0,04 g/Liter δ-Valerolactam-octa-ethoxylat oder
0,03 g/Liter ε-Caprolactam-dodeca-ethoxylat
zu, so ist der gesamte Stromdichtebereich auf dem Hullzellen-Prüfblech glänzend.

### Beispiel 4

Einem Kupferbad folgender Zusammensetzung
60 g/Liter Kupfersulfat (CuSO₄·5 H₂O)
220 g/Liter Schwefelsäure konz.
0,1 g/Liter Natriumchlorid
werden
1,0 g/Liter Nonylphenol-polyglykolether und
0,04 g/Liter 3-(Benzthiazolyl-2-thio)-propylsulfonsäure, Natriumsalz
zugegeben.

In dem ausschließlich warenbewegten Bad wird bei einer mittleren Stromdichte von 2 A/dm² eine gedruckte, nach der Additivtechnik verkupferte Schaltung 60 Minuten lang verstärkt. Hierbei zeigen sich um die Bohrlöcher herum matte Höfe, die nach dem Verzinnen deutliche Risse aufweisen.

Setzt man dem Bad außerdem 50 mg/Liter ε-Caprolactam-hexa-ethoxylat zu, sind die Bohrlöcher - auch nach dem Verzinnen - einwandfrei.

### Beispiel 5

Eine Kupferfolie von 40 µm Dicke, die aus folgendem Bad mit 2.5 A/dm² abgeschieden wurde:
80 g/Liter Kupfersulfat (CuSO₄·5 H₂O)
200 g/Liter Schwefelsäure konz.
0,06 g/Liter Natriumchlorid
und
0,4 g/Liter Octanolpolyalkylenglykolether
0,01 g/Liter Bis-(ω-sulfopropyl)-disulfid. Dinatriumsalz,
zeigt eine Bruchelongation von 18 %. Nach Zugabe von 0.05 g/Liter ω-Caprolactam-hexa-ethoxylat wird erneut eine Kupferfolie abgeschieden. Die Bruchelongation verbessert sich auf 24 %. Weitere Zugaben verbessern hier den Wert der Bruchelongation nur noch unwesentlich.

### Beispiel 6

Einem Kupferbad der Zusammensetzung
200 g/Liter Kupfersulfat (CuSO₄·5 H₂O)
60 g/Liter Schwefelsäure konz.
0,1 g/Liter Salzsäure (35 %ig)
werden
10 mg/Liter Mercaptopropansulfonsäure, Na-Salz
und
50 mg/Liter ε-Caprolactam-hexa-ethoxylat
zugesetzt. Die Abscheidung ist in der Hullzelle von 0,2 A/dm² bis 7 A/dm² gut glänzend.

## Patentansprüche

1. Wäßriges, saures Bad zur galvanischen Abscheidung von glänzenden und rißfreien Kupferüberzügen, insbesondere zur Verstärkung der Leiterbahnen von gedruckten Schaltungen mit hervorragender Bruchelongation, das mindestens ein Kupfersalz und mindestens eine anorganische Säure sowie eine eine Amidgruppe aufweisende Verbindung und eine organische Thioverbindung mit wasserlöslich machenden Gruppen enthält, dadurch gekennzeichnet, daß das Bad mindestens ein Lactamalkoxylat als Amidgruppe aufweisende Verbindung enthält.

2. Bad nach Anspruch 1, gekennzeichnet durch ein Lactamalkoxylat der allgemeinen Formel 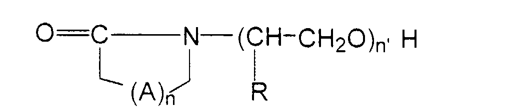
worin A einen Kohlenwasserstoffrest,
R Wasserstoff oder Methyl,
n eine ganze Zahl von 2 bis 10, vorzugsweise von 2 bis 5, und
n' eine ganze Zahl von 1 bis 50
darstellen.

3. Bad nach Anspruch 2, dadurch gekennzeichnet, daß A einen Alkylenrest der Formel
-CH₂ -
darstellt.

4. Bad nach einem der vorstehenden Ansprüche, gekennzeichnet durch
β-Propiolactam-ethoxylat,
γ-Butyrolactam-hexa-ethoxylat,
δ-Valerolactam-octa-ethoxylat,
δ-Valerolactam-penta-propoxylat,
ε-Caprolactam-hexa-ethoxylat,
ε-Caprolactam-dodeca-ethoxylat
als Lactamalkoxylate.

5. Bad nach einem der vorstehenden Ansprüche, dadurch gekennzeichnet, daß das Lactamalkoxylat in einer Konzentration von 0,002 bis 3 g/Liter, vorzugsweise von 0,005 bis 0,2 g/Liter, enthalten ist.

6. Bad nach einem der vorstehenden Ansprüche, dadurch gekennzeichnet, daß das Bad zusätzlich ein Chlorid enthält.

7. Bad nach einem der vorstehenden Ansprüche, dadurch gekennzeichnet, daß das Bad
3-Mercaptopropan-1-sulfonsäure, Natriumsalz,
Thiophosphorsäure-O-ethyl-bis-(ω-sulfopropyl)-ester, Dinatriumsalz,
Thiophosphorsäure-tris-(ω-sulfopropyl)-ester, Trinatriumsalz,
Thioglykolsäure,
Ethylendithiodipropylsulfonsäure, Natriumsalz,
Di-n-propyl-thioether-di-ω-sulfonsäure, Dinatriumsalz,
Bis-(ω-sulfopropyl)-disulfid, Dinatriumsalz,
Bis-(ω-sulfohydroxypropyl)-disulfid, Dinatriumsalz,
Bis-(ω-sulfobutyl)-disulfid, Dinatriumsalz,
Bis-(p-sulfophenyl)-disulfid, Dinatriumsalz,
Methyl-(ω-sulfopropyl)-disulfid, Natriumsalz,
Methyl-(ω-sulfobutyl)-trisulfid, Natriumsalz,
3-(Benzthiazolyl-2-thio)-propylsulfonsäure, Natriumsalz,
N,N-Dimethyl-dithiocarbaminsäure-(3-sulfopropyl)-ester, Natriumsalz oder
O-Ethyl-dithiokohlensäure-S-(3-sulfopropyl)-ester, Kaliumsalz
als organische Thioverbindungen mit wasserlöslich machender Gruppe in einer Konzentration von 0,0005 bis 0,2 g/Liter, vorzugsweise von 0,001 bis 0,05 g/Liter, enthält.

8. Bad nach einem der vorstehenden Ansprüche, dadurch gekennzeichnet, daß das Bad zusätzlich eine sauerstoffhaltige, hochmolekulare organische Verbindung, vorzugsweise
Polyvinylalkohol,
Carboxymethylcellulose,
Polyethylenglykol,
Polypropylenglykol,
Stearinsäure-polyglykolester,
Ölsäure-polyglykolester,
Stearylalkohol-polyglykolether,
Nonylphenol-polyglykolether,
Octanol-polyalkylenglykolether,
Octandiol-bis-(polyalkylenglykolether),
Polyoxypropylenglykol,
Polyethylen-propylenglykol (Misch- oder Blockpolymerisat) oder
β-Naphthol-polyglykolether,
in einer Konzentration von 0,005 bis 20 g/Liter, vorzugsweise von 0,01 bis 5 g/Liter, enthält

9. Bad nach einem der vorstehenden Ansprüche, dadurch gekennzeichnet, daß zusätzliche Glanzbildner und/oder Netzmittel enthalten sind.

10. Verwendung des Bades nach einem der Ansprüche 1 bis 9 zur Verstärkung der Leiterbahnen von gedruckten Schaltungen.

## Claims

1. Aqueous, acidic bath for the electrodeposition of shiny and crack-free copper coatings, more especially for reinforcing the conductor paths of printed circuits having excellent breaking elongation, which bath contains at least one copper salt and at least one inorganic acid as well as a compound having an amide group and an organic thio compound having water-soluble rendering groups, characterised in that the bath contains at least one compound having lactam alkoxylate as the amide group.

2. Bath according to claim 1, characterised by a lactam alkoxylate of the general formula 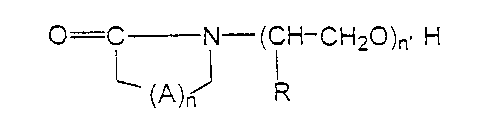
in which A represents a hydrocarbon radical,
R represents hydrogen or methyl,
n represents a whole number between 2 and 10, preferably between 2 and 5, and
n' represents a whole number between 1 and 50.

3. Bath according claim 2, characterised in that A represents an alkylene radical of the formula
-CH₂-

4. Bath according to one of the preceding claims, characterised by
β-propiolactam ethoxylate,
γ-butyrolactam-hexa-ethoxylate,
δ-valerolactam-octa-ethoxylate,
δ-valerolactam-penta-propoxylate,
ε-caprolactam-hexa-ethoxylate,
ε-caprolactam-dodeca-ethoxylate
as the lactam alkoxylates.

5. Bath according to one of the preceding claims, characterised in that the lactam alkoxylate is contained in a concentration of between 0.002 and 3 g/litre, preferably between 0.005 and 0.2 g/litre.

6. Bath according to one of the preceding claims, characterised in that the bath additionally contains a chloride.

7. Bath according to one of the preceding claims, characterised in that the bath contains
3-mercaptopropane-1-sulphonic acid, sodium salt,
thiophosphoric acid-O-ethyl-bis-(ω-sulphopropyl)-ester, disodium salt,
thiophosphoric acid-tris-(ω-sulphopropyl)-ester, trisodium salt,
thioglycolic acid,
ethylene dithiodipropyl sulphonic acid, sodium salt,
di-n-propyl-thioether-di-ω-sulphonic acid, disodium salt,
bis-(ω-sulphopropyl)-disulphide, disodium salt,
bis-(ω-sulphohydroxypropyl)-disulphide, disodium salt,
bis-(ω-sulphobutyl)-disulphide, disodium salt,
bis-(p-sulphophenyl)-disulphide, disodium salt,
methyl-(ω-sulphopropyl)-disulphide, sodium salt,
methyl-(ω-sulphobutyl)-trisulphide, sodium salt,
3-(benzothiazolyl-2-thio)-propyl sulphonic acid, sodium salt,
N,N-dimethyl-dithiocarbamic acid-(3-sulphopropyl)-ester, sodium salt,
or
O-ethyl-dithio carbonic acid-S-(3-sulphopropyl)-ester, potassium salt
as organic thio compounds having a water-soluble rendering group in a concentration of between 0.0005 and 0.2 g/litre, preferably between 0.001 and 0.05 g/litre.

8. Bath according to one of the preceding claims, characterised in that the bath additionally contains an oxygen-containing, high-molecular organic compound, preferably
polyvinyl alcohol,
carboxymethyl cellulose,
polyethylene glycol,
polypropylene glycol,
stearic acid polyglycol ester,
oleic acid polyglycol ester,
stearyl alcohol polyglycol ether,
nonylphenol polyglycol ether,
octanol polyalkylene glycol ether,
octandiol-bis-(polyalkylene glycol ether),
polyoxypropylene glycol,
polyethylene-propylene glycol (mixed or block polymeride) or
β-naphthol polyglycol ether
in a concentration of between 0.005 and 20 g/litre, preferably between 0.01 and 5 g/litre.

9. Bath according to one of the preceding claims, characterised in that it contains additional brighteners and/or wetting agents.

10. Use of the bath according to one of claims 1 to 9 for reinforcing the conductor paths of printed circuits.

## Revendications

1. Bain acide aqueux pour le dépôt électrolytique de revêtements cuivrés brillants exempts de fissures, en particulier pour le renforcement des pistes conductrices de circuits imprimés avec un allongement à la rupture excellent, contenant au moins un sel de cuivre et au moins un acide inorganique ainsi qu'un composé présentant un groupe amide et un thiocomposé organique avec des groupes hydrosolubilisants, caractérisé en ce que le bain contient au moins un alcoxylate de lactame comme composé présentant un groupe amide.

2. Bain selon la revendication 1, caractérisé par un alcoxylate de lactame de la formule générale 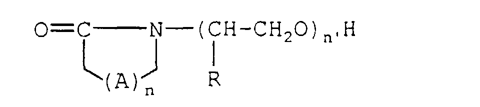 dans laquelle
A est un résidu hydrocarbure,
R est hydrogène ou méthyle,
n est un entier de 2 à 10, de préférence de 2 à 5, et
n' est un entier de 1 à 50.

3. Bain selon la revendication 2, caractérisé en ce que A est un résidu alkylène de la formule
-CH₂-

4. Bain selon l'une des revendications précédentes, caractérisé par les
éthoxylate de β-propio[actame,
hexaéthoxvlate de γ-butyrolactame,
octaéthoxylate de δ-valérolactame,
pentapropoxylate de δ-valérolactame,
hexaéthoxylate de ε-caprolactame,
dodécaénhozylate de ε-capiolactame,
comme alcoxylates de lactame.

5. Bain selon l'une des revendications précédentes, caractérisé en ce que l'alcoxylate de lactame est présent à une concentration de 0,002 à 3 g/litre, de préférence de 0,005 à 0,2 g/litre.

6. Bain selon l'une des revendications précédentes, caractérisé en ce que le bain contient en plus un chlorure.

7. Bain selon l'une des revendications précédentes, caractérisé en ce que le bain contient
acide 3-mercapto-1-sulfonique sel de sodium ;
thiophosphate de O-éthyl-bis-(ω-sulfopropyle), sel disodique ;
thiophosphate de tris-(ω-sulfopropyle), sel trisodique ;
acide thioglycolique ;
acide éthylène dithiodipropylsulfonique, sel de sodium ;
acide di-n-propylthioéther-di-ω-sulfonique, sel disodique ;
disulfure de bis-(ω-sulfopropyle), sel disodique ;
disulfure de bis-(ω-sulfohydroxypropyle), sel disodique ;
disulfure de bis-(ω-sulfobutyle), sel disodique ;
disulfure de bis-(p-sulfophényle), sel disodique ;
disulfure de méthyl-(ω-sulfopropyle), sel de sodium ;
trisulfure de méthyl-(ω-sulfobutyle), sel de sodium ;
acide 3-(benzthiazolyl-2-thio)-propylsulfonique, sel de sodium ;
N,N-diméthyldithiocarbamate de 3-sulfopropyle, sel de sodium ; ou
O-éthyl-dithiocarbonate de S-(3-sulfopropyle), sel de potassium,
comme thiocomposé organique avec des groupes hydro-solubilisants à une concentration de 0,0005 à 0,2 g/litre, de préférence de 0,001 à 0,05 g/litre.

8. Bain selon l'une des revendications précédentes, caractérisé en ce que le bain contient en plus un composé organique de haut poids moléculaire contenant de l'oxygène, de préférence
alcool polyvinylique,
carboxyméthylcellulose,
polyéthylène glycol,
polypropylène glycol,
stéarate de polyglycol,
oléate de polyglycol,
éther polyglycolique de l'alcool stéarylique,
éther polyglycolique de nonylphénol,
éther polyalkylène glycolique d'octanol,
éther bis-(polyalkylène glycolique) d'octandiol,
polyoxypropylène glycol,
polyéthylène-propylène glycol (copolymère ou polymère en masse), ou
éther polyglycolique de β-naphtol,
à une concentration de 0,005 à 20 g/litre, de préférence de 0,01 à 5 g/litre.

9. Bain selon l'une des revendications précédentes, caractérisé en ce qu'il contient en plus des agents de brillantage et/ou des agents mouillants.

10. Utilisation du bain selon l'une des revendications 1 à 9 pour renforcer des pistes conductrices de circuits imprimés.
